# EUROPEAN PATENT SPECIFICATION

(11) **EP 4 166 959 B1**
(45) Date of publication and mention of the grant of the patent: **11.02.2026**
(21) Application number: 21830001.0
(22) Date of filing: 18.06.2021
(51) Int. Cl.: G01R 31/36, G01R 31/3835, G01R 31/3842

(54) **METHOD FOR MEASURING BATTERY RESERVE CAPACITY OF STORAGE BATTERY, AND BATTERY DETECTION DEVICE**
VERFAHREN ZUR MESSUNG DER BATTERIERESERVEKAPAZITÄT EINER SPEICHERBATTERIE UND BATTERIEERKENNUNGSVORRICHTUNG
PROCÉDÉ DE MESURE DE CAPACITÉ DE RÉSERVE DE BATTERIE DE BATTERIE RECHARGEABLE ET DISPOSITIF DE DÉTECTION DE BATTERIE

(30) Priority: 24.06.2020 CN 202010592274
(43) Date of publication of application: 19.04.2023
(73) Proprietor: Autel Intelligent Technology Corp., Ltd., Shenzhen, Guangdong 518055 (CN)
(72) Inventor: FENG, Guangwen, Shenzhen, Guangdong 518055 (CN); QU, Songsong, Shenzhen, Guangdong 518055 (CN)
(74) Representative: Harris, Oliver John Richard
(86) International application number: PCT/CN2021/100817
(87) International publication number: WO 2021/259154

(56) References cited:
- CN-A- 102 656 469
- CN-A- 103 176 132
- CN-A- 103 969 587
- CN-A- 105 807 230
- CN-A- 109 991 548
- CN-A- 111 596 220
- JP-A- 2018 141 665
- US-A1- 2005 218 902
- US-A1- 2011 316 548
- US-A1- 2013 138 370

## Description

### Technical Field

The present application relates to the technical field of battery detection, and in particular to a method for measuring a battery reserve capacity of a storage battery and a battery detection device.

### Background Art

Traditionally, automobiles are provided with a storage battery for supplying power to the engine starting and on-board electrical equipment of the automobile. The battery reserve capacity (RC, also referred to as the remaining electric quantity or remaining capacity) of a storage battery refers to the time (in minutes) required for the storage battery to discharge to 10.5V at a current of 25A, which represents the battery's ability as the sole energy source to provide a continuous current of 25A for electrical equipment such as ignition and lighting when the charging system of an automobile fails. At present, the prior art mostly uses a constant-current discharge device to discharge a storage battery to 10.5V at a constant current of 25A. By measuring the time of the above process, the measurement of the battery reserve capacity of the storage battery is realized. However, the measurement time of the above-described measurement method is long, which reduces the measurement efficiency of the battery reserve capacity of the storage battery. US 2013/138370 A1, US 2005/218902 A1, and US 2011/316548 A1 disclose conventional methods for measuring battery reserve capacity of a storage battery, and corresponding battery detection devices.

### Summary of the Invention

The invention is defined by the appended set of claims. The description that follows is subjected to this limitation. Any disclosure lying outside the scope of said claims is only intended for illustrative as well as comparative purposes.

Embodiments of the present invention aim at providing a method for measuring a battery reserve capacity of a storage battery and a battery detection device capable of reducing the measurement time of the battery reserve capacity of the storage battery and improving the measurement efficiency.

Advantageous effects of the present invention are: in comparison with the prior art, embodiments of the present invention provide a method for measuring a battery reserve capacity of a storage battery and a battery detection device, comprising sending an input signal to the storage battery to control the discharge of the storage battery, acquiring an output signal fed back by the storage battery for an input signal within an input duration of the input signal, determining a target battery parameter according to the output signal, acquiring a battery capacity table, the battery capacity table including a correlation between the battery parameter and the battery reserve capacity, and determining the battery reserve capacity corresponding to the target battery parameter according to the battery capacity table and the target battery parameter. Therefore, an embodiment of the present invention obtains the target battery parameter by controlling the storage battery to perform at least one discharge, and measures the battery reserve capacity of the storage battery according to the target battery parameter and the battery capacity table including the correlation between the battery parameter and the battery reserve capacity, thereby reducing the measurement time of the battery reserve capacity of the storage battery and improving the measurement efficiency.

### Brief Description of the Drawings

One or more embodiments are illustrated by way of examples with a figure in the corresponding drawings. The illustrative examples are not to be construed as limiting the embodiments. In the drawings, elements having the same reference numeral designations represent like elements, and unless otherwise specified, the drawings are not to scale.
Fig. 1 is a schematic view of a circuit structure of a battery detection device according to an embodiment of the present invention;
Fig. 2 is a schematic view of a circuit structure of a discharge circuit and a voltage sampling circuit shown in Fig. 1;
Fig. 3 is a schematic view of the circuit connection of a battery detection device according to an embodiment of the present invention;
Fig. 4 is a method flow diagram of a method for measuring a battery reserve capacity of a storage battery according to an embodiment of the present invention.

### Detailed Description of the Invention

In order that the present application may be readily understood, a more particular description of the application will be rendered below by reference to specific implementation modes and the accompanying drawings. It needs to be noted that when one element is referred to as being "connected" to another element, it can be directly connected to the other element or one or more intermediate elements may be present between the elements. Furthermore, the terms "first", "second", and the like are used for descriptive purposes only and are not to be construed as indicating or implying relative importance.

Unless defined otherwise, all technical and scientific terms used in the description have the same meaning as commonly understood by one of ordinary skill in the art to which this invention belongs. The terms used in the description of the present invention are for the purpose of describing specific implementation modes only and are not intended to be limiting of the present invention. As used in the description, the term "and/or" includes any and all combinations of one or more of the associated listed items.

Furthermore, the technical features involved in various embodiments of the present application described below can be combined as long as they do not conflict with each other.

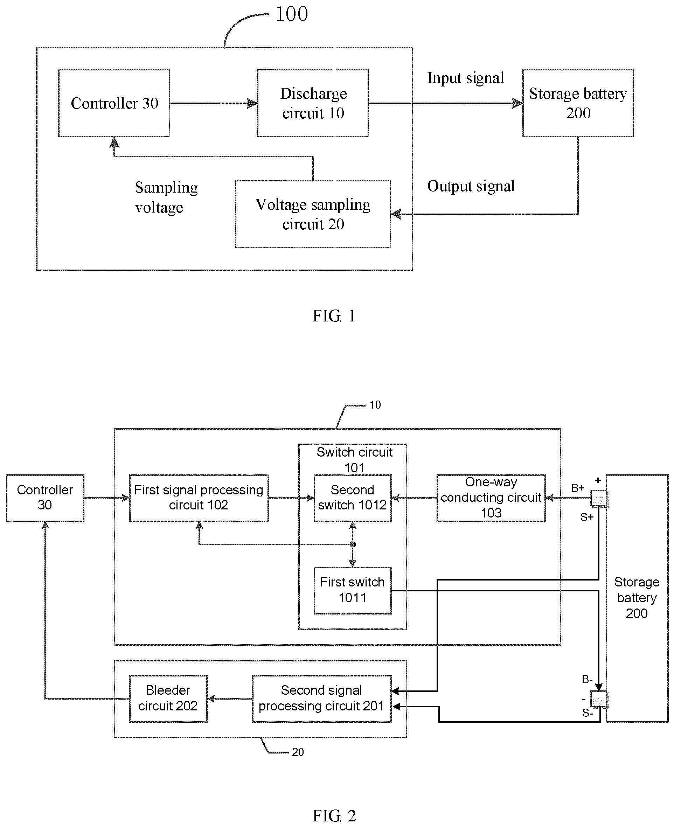

Referring to Fig. 1, a schematic view of a circuit structure of a battery detection device according to an embodiment of the present invention is shown. As shown in Fig. 1, a battery detection device 100, which includes a discharge circuit 10, a voltage sampling circuit 20, and a controller 30, is electrically connected to a storage battery 200 through a Kelvin connector (not shown).

As shown in Fig. 2, the Kelvin connector includes a B+ connecting line, a B- connecting line, an S+ connecting line, and an S- connecting line. The B+ connecting line and the S+ connecting line are both electrically connected to the positive electrode of the storage battery 200, the B-connecting line and the S- connecting line are both electrically connected to the negative electrode of the storage battery 200, the B+ connecting line and the B- connecting line are used for separating the discharge current between the two electrodes of the storage battery 200, and the S+ connecting line and the S- connecting line are used for separating the open circuit voltage between the two electrodes of the storage battery 200. The Kelvin four-wire detection is realized by the Kelvin connector, and the impedance of the wiring and contact resistor is eliminated. The contact resistor refers to the resistor when the current flows through the positive electrode of the storage battery 200 or the negative electrode of the storage battery 200 when the battery detection device 100 forms a discharge loop with the storage battery 200.

The discharge circuit 10 is electrically connected to the storage battery 200 through a Kelvin connector for sending an input signal to the storage battery 200 to control the discharge of the storage battery 200.

In an embodiment of the invention, the input signal is the discharge current at which the storage battery 200 discharges. When the discharge circuit 10 sends a discharge current to the storage battery 200, the discharge circuit 10 is in a conducting state, and the discharge circuit 10 forms a discharge loop with the storage battery 20, triggering the storage battery 200 to start discharging, i.e. the input signal can be used to control the storage battery 200 to discharge.

Referring to Fig. 2 together, the discharge circuit 10 includes a switch circuit 101 and a first signal processing circuit 102.

The switch circuit 101 is electrically connected to the controller 30, and is electrically connected to the storage battery 200 through a Kelvin connector for triggering a discharge current to be sent to the storage battery 200 and generating a trigger signal when the controller 30 controls the switch circuit 101 to be in a conductive state.

Further, the switch circuit 101 includes a first switch 1011 and a second switch 1012.

The first switch 1011 is electrically connected to the controller 30 and the first signal processing circuit 102 respectively, and is electrically connected to the negative electrode of the storage battery 200 via a Kelvin connector for controlling, according to a control signal sent by the controller 30, to close or disconnect a discharge loop of the controller 30 and the storage battery 200, generating a trigger signal, and sending the trigger signal to the first signal processing circuit 102.

The first switch 1011 is electrically connected to one end of the B- connecting line, and the other end of the B- connecting line is electrically connected to the negative electrode of the storage battery BAT1.

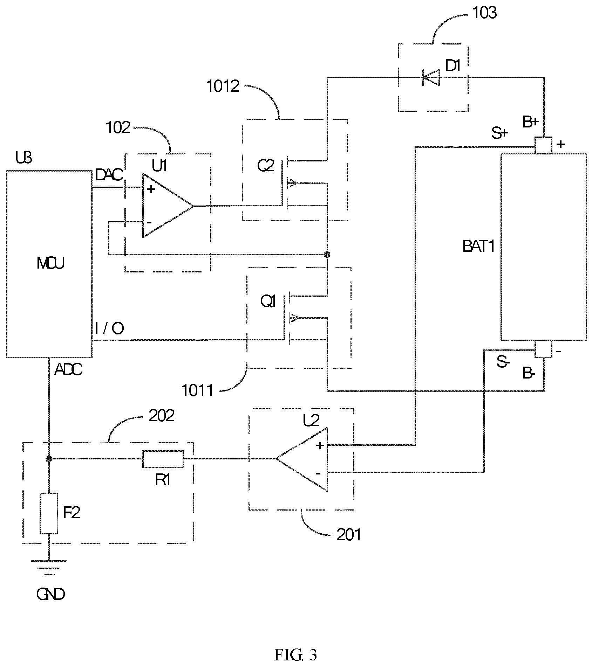

Referring to Fig. 3, the first switch 101 comprises a first PMOS tube Q1, a gate electrode of the first PMOS tube Q1 is electrically connected to the controller 30 (an I/O port of the single chip microcomputer U3), a source electrode of the first PMOS tube Q1 is electrically connected to the negative electrode of the storage battery BAT1 via a Kelvin connector (B- connecting line), and a drain electrode of the first PMOS tube Q1 is electrically connected to the second switch 1012 and the first signal processing circuit 102. When the first PMOS tube Q1 is turned on, the drain electrode of the first PMOS tube Q1 is pulled to a low level, a trigger signal is generated, and the trigger signal of the low level is sent to the first signal processing circuit 102.

The second switch 1012 is electrically connected to the first switch 1011 and the first signal processing circuit 102, respectively, and is electrically connected to the positive electrode of the storage battery 200 via a Kelvin connector for controlling the magnitude of the discharge current of the discharge loop according to the driving signal output by the first signal processing circuit 102.

The second switch 1012 is electrically connected to one end of the B+ connecting line, and the other end of the B+ connecting line is electrically connected to the positive electrode of the storage battery BAT1.

As shown in Fig. 3, the second switch 1012 comprises a second PMOS tube Q2. The gate electrode of the second PMOS tube Q2 is electrically connected to the first signal processing circuit 102, the source electrode of the second PMOS tube Q2 is electrically connected to the drain electrode of the first PMOS tube and the first signal processing circuit 102, and the drain electrode of the second PMOS tube Q2 is electrically connected to the positive electrode of the storage battery BAT1 via a Kelvin connector (B+ connecting line). When the first PMOS tube Q1 is turned on, the drain electrode of the first PMOS tube Q1 is pulled to the low level, a trigger signal is generated, and the trigger signal of the low level is sent to the first signal processing circuit 102; the first signal processing circuit 102 generates a driving signal; the driving signal acts on the gate electrode of the second PMOS tube Q2 to control the second PMOS tube Q2 to be conductive; when the second PMOS tube Q2 is conductive, the drain electrode current of the second PMOS tube Q2 depends on the gate electrode voltage of the second PMOS tube Q2. The drain electrode current of the second PMOS tube Q2 is equal to the discharge current of a discharge loop from the positive electrode of the storage battery BAT1, the second PMOS tube Q2, and the first PMOS tube Q1, to the negative electrode of the storage battery BAT1.

The first signal processing circuit 102 is electrically connected to the controller 30 and the switch circuit 101, respectively, and is used for performing signal processing on the voltage signal sent by the controller 30 and the trigger signal sent by the switch circuit 101, and outputting a driving signal to control the magnitude of the discharge current.

As shown in Fig. 3, the first signal processing circuit 102 comprises a first operational amplifier U1. An in-phase input end of the first operational amplifier U1 is electrically connected to the controller 30 (the DAC port of the single chip microcomputer U3), an inverting input end of the first operational amplifier U1 is electrically connected to the drain electrode of the first PMOS tube Q1 and the source electrode of the second PMOS tube Q2, and an output end of the first operational amplifier U1 is electrically connected to the gate electrode of the second PMOS tube Q2. The in-phase input end of the first operational amplifier U1 is used to receive the voltage signal sent by the controller 30, the inverting input end of the first operational amplifier U1 is used for receiving a trigger signal output by the first PMOS tube Q1, and the first operational amplifier U1 performs signal processing on the voltage signal and the trigger signal and outputs a driving signal. Therefore, the magnitude of the driving signal is related to the magnitude of the voltage signal, and the discharge current of the discharge loop from the positive electrode of the storage battery BAT1, the second PMOS tube Q2, and the first PMOS tube Q1 to the negative electrode of the battery BAT1 can be adjusted by adjusting the voltage signal sent from the controller 30.

In some embodiments, the discharge circuit 10 further includes a one-way conducting circuit 103 electrically connected between the second switch 1012 and the positive electrode of the storage battery 200 for preventing the discharge current from flowing back to the positive electrode of the storage battery 200.

One end of the one-way conducting circuit 103 is electrically connected to the second switch 1012, and the other end of the one-way conducting circuit 103 is electrically connected to one end of the B+ connecting line.

As shown in Fig. 3, the one-way conducting circuit 103 comprises a diode D1. The anode of the diode D1 is electrically connected to the positive electrode of the storage battery BAT1, and the cathode of the diode D1 is electrically connected to the drain electrode of the second PMOS tube Q2. With the unidirectional conductivity of the diode, in the external circuit of the storage battery BAT1, the discharge current always flows from the positive electrode of the storage battery BAT1 through the second PMOS tube Q2, the first PMOS tube Q1, and finally back to the negative electrode of the storage battery BAT1, thus preventing the current from flowing backward which causes the burning of the battery BAT1.

The voltage sampling circuit 20 is electrically connected to the storage battery 200 via a Kelvin connector for sampling an output signal fed back by the storage battery 200 for the input signal within the input duration of the input signal to obtain a sampling voltage.

Here, the output signal is an open circuit voltage fed back by the storage battery 200 for the discharge current during the input duration. The open circuit voltage is the voltage between the positive electrode of the storage battery 200 and the negative electrode of the storage battery 200 when the storage battery 200 is discharged, and the voltage sampling circuit 20 samples the open circuit voltage of the storage battery 200 through the S+ connecting line and the S-connecting line of the Kelvin connector.

Referring again to Fig. 2, the voltage sampling circuit 20 includes a second signal processing circuit 201 and a bleeder circuit 202.

The second signal processing circuit 201 is electrically connected to the storage battery 200 through a Kelvin connector for performing signal processing on the open circuit voltage of the storage battery 200.

The second signal processing circuit 201 is electrically connected to one end of the S+ connecting line and one end of the S- connecting line, respectively. The other end of the S+ connecting line is electrically connected to the positive electrode of the storage battery BAT1, and the other end of the S- connecting line is electrically connected to the negative electrode of the storage battery BAT1.

As shown in Fig. 3, the second signal processing circuit 201 comprises a second operational amplifier U2, the in-phase input end of the second operational amplifier U2 is electrically connected to the positive electrode of the storage battery BAT1 through the Kelvin connector (S+ connecting line), the inverting input end of the second operational amplifier U2 is electrically connected to the negative electrode of the storage battery BAT1 via a Kelvin connector (S- connecting line), and an output end of the second operational amplifier U2 is electrically connected to the bleeder circuit 202.

The bleeder circuit 202 is electrically connected to the second signal processing circuit 201 and the controller 30 respectively, and is used for performing voltage dividing processing on the output voltage of the second signal processing circuit 201 to obtain a sampling voltage, so that the controller 30 determines a target battery parameter according to the sampling voltage.

As shown in Fig. 3, the bleeder circuit 202 includes a first resistor R1 and a second resistor R2. One end of the first resistor R1 is electrically connected to the output end of the second operational amplifier U2, and the other end of the first resistor R1 is electrically connected to the controller 30 (an ADC port of the single chip microcomputer U3) and one end of the second resistor R2; the other end of the second resistor R2 is grounded.

The controller 30 is electrically connected to the discharge circuit 10 and the voltage sampling circuit 20 respectively, and is used for controlling the discharge circuit 10 so that the discharge circuit 10 sends an input signal to the storage battery 200, determines a target battery parameter according to the sampling voltage, and acquires a battery capacity table. The battery capacity table comprises a correlation between the battery parameter and the battery reserve capacity, and determines the battery reserve capacity corresponding to the target battery parameter according to the battery capacity table and the target battery parameter.

As shown in Fig. 3, the controller 30 comprises a single chip microcomputer U3. The single chip microcomputer U3 can adopt 51 series, Arduino series, STM32 series, etc. and the single chip microcomputer U3 comprises an I/O port, a DAC port, and an ADC port. The I/O port of the single chip microcomputer U3 is electrically connected to the gate electrode of the first PMOS tube Q1, the DAC port of the single chip microcomputer U3 is electrically connected to the in-phase input end of the first operational amplifier U1, and the ADC port of the single chip microcomputer U3 is electrically connected to a connection joint of the first resistor R1 and the second resistor R2.

In some embodiments, the controller 30 may also be a general purpose processor, a digital signal processor (DSP), an application specific integrated circuit (ASIC), a field programmable gate array (FPGA), an ARM (Acorn RISC Machine) or other programmable logic devices, discrete gate or transistor logic, discrete hardware assemblies, or any combination of these components; it can also be any conventional processor, controller, microcontroller or state machine; it may also be implemented as a combination of computing equipment, e.g. a combination of a DSP and a microprocessor, multiple microprocessors, one or more microprocessors combined with DSP core, or any other such configuration.

In summary, the working process of the battery detection device 100 is as follows.
(1) The I/O port of the single chip microcomputer U3 outputs a high-level signal, and when the DAC port of the single chip microcomputer U3 outputs a voltage signal, the high-level signal acts on the gate electrode of the first PMOS tube Q1 to satisfy the conduction condition of the first PMOS tube Q1; the first PMOS tube Q1 is turned on, and the drain electrode voltage of the first PMOS tube Q1 is pulled low, namely, the inverting input end of the first operational amplifier U1 is a low level, and the first operational amplifier U1 performs signal processing on the voltage signal input by the in-phase input end and the low level signal input by the inverting input end to obtain a driving signal; wherein the magnitude of the driving signal is related to the magnitude of the voltage signal, and the driving signal acts on the gate electrode of the second PMOS tube Q2 to satisfy the conduction condition of the second PMOS tube Q2; the second PMOS tube Q2 is turned on, and at this moment, the positive electrode of the storage battery BAT1, the diode D1, the second PMOS tube Q2, the first PMOS tube Q1, and the negative electrode of the storage battery BAT1 form a discharge loop therebetween; the storage battery BAT1 discharges at a constant discharge current, wherein the magnitude of the discharge current is related to the magnitude of the driving signal.

When the storage battery BAT1 discharges at a constant discharge current, the storage battery BAT1 generates an open circuit voltage; an in-phase input end of the second operational amplifier U2 is electrically connected to the positive electrode of the storage battery BAT1; the inverting input end of the second operational amplifier U2 is electrically connected to the negative electrode of the storage battery BAT1; the second operational amplifier U2 performs signal processing on the open circuit voltage, then performs voltage dividing processing via a bleeder circuit composed of a first resistor R1 and a second resistor R2 to obtain a sampling voltage, and sends the sampling voltage to the ADC port of the single chip microcomputer U3. According to the sampling voltage, the single chip microcomputer U3 detects the maximum voltage and the minimum voltage of the open circuit voltage during this discharging process, calculates the voltage drop slope according to the maximum voltage, the minimum voltage, and the discharge duration of storage battery BAT1, and stores the set of battery parameters.

(2) The I/O port of the single chip microcomputer U3 outputs a low level signal; the low level signal acts on the gate electrode of the first PMOS tube Q1, and does not satisfy the conduction condition of the first PMOS tube Q1; the first PMOS tube Q1 is cut off, the discharge loop of the storage battery BAT1 is turned off, and the storage battery BAT1 stops discharging.

(3) Steps (1) and (2) are repeated; the storage battery is controlled to perform intermittent constant-current discharge so as to obtain several sets of battery parameters; the single chip microcomputer U3 determines a target battery parameter from several sets of battery parameters according to a preset algorithm so that the single chip microcomputer U3 determines a battery reserve capacity corresponding to the target battery parameter according to the target battery parameter and a battery capacity table.

The above-mentioned product can execute the method provided by the embodiments of the present invention, and has corresponding functional modules and advantageous effects for executing the method. Technical details not described in detail in the embodiment can be found in the method provided in the embodiments of the present invention.

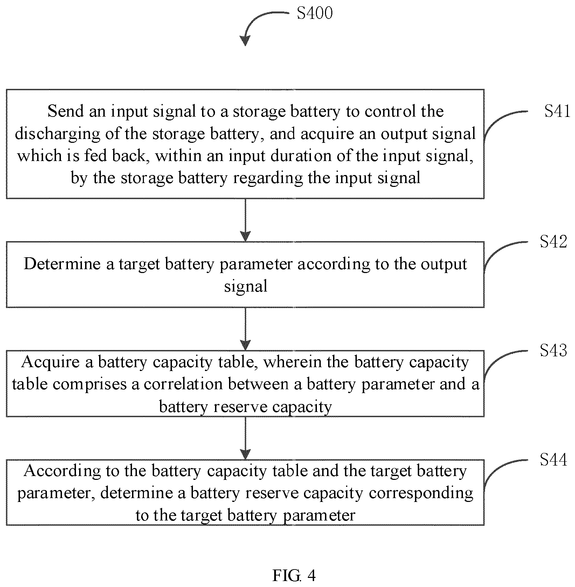

Referring to Fig. 4, a method flow diagram of a method for measuring a battery reserve capacity of a storage battery according to an embodiment of the present invention is shown. As shown in Fig. 4, a method S400 for measuring a battery reserve capacity of a storage battery is applied to the battery detection device 100 according to any of the embodiments described above, the battery detection device 100 being electrically connected to the storage battery 200 through a Kelvin connector. The method comprises:
step S41, sending an input signal to a storage battery to control the discharging of the storage battery, and acquiring an output signal which is fed back, within an input duration of the input signal, by the storage battery regarding the input signal.

It could be understood that the battery detection device may send an input signal to the storage battery at least once. Each time when the input signal is sent to the storage battery, the storage battery is continuously discharged during the input duration of the input signal, and the output signal is returned to the battery detection device. When the input duration of the input signal ends, the storage battery ends discharging, and the return of the output signal to the battery detection device is stopped.

In some embodiments, sending an input signal to the storage battery to control the discharging of the storage battery comprises: sending an input signal to the storage battery at least twice to control the discharging of the storage battery.

As one of the implementation modes of the present invention, sending an input signal to the storage battery at least twice to control the discharging of the storage battery comprises: sending an input signal to the storage battery at least twice at a preset frequency to control the discharging of the storage battery.

Here, the input signal of a preset frequency can be generated by means of a timer interrupt, i.e. the sending interval of at least two transmissions of the input signal is equal.

As one of the implementation modes of the present invention, sending interval for at least two transmissions of the input signal is random, i.e. the sending interval duration is not predetermined, and may be the same or different. For example, a randomly occurring input signal may be generated by a preset algorithm.

As one of the implementation modes of the present invention, sending an input signal to the storage battery at least twice to control the discharging of the storage battery comprises: sending an input signal to the storage battery at least twice to control the storage battery to discharge up to a preset number of times.

Specifically, the number of times of sending an input signal to the storage battery is detected by means of a counter such that it is determined whether the number of times of discharging the storage battery reaches a preset number of times; if so, the sending of the input signal to the storage battery is stopped, thereby realizing at least two times of sending the input signal to the storage battery to control the storage battery to discharge until the preset number of times.

The preset number of times can be set according to the rated parameter of the storage battery, for example, by presetting a mathematical relationship between the rated parameter and the preset number of times, detecting the rated parameter of the storage battery, and determining the preset number of times according to the rated parameter of the storage battery and the mathematical relationship between the rated parameter and the preset number of times. When the rated current of the storage battery is large, the numerical value of a preset number of times can be reduced so as to reduce the heat generated by discharging the storage battery. The preset number of times can also be manually set according to historical experience values. For example, for a 100RC storage battery: when an input signal is sent to the storage battery to control the storage battery to discharge until 20 times, the measurement result of the battery reserve capacity of the storage battery is equal to a total of 20 times of 100RC; when an input signal is sent to the storage battery to control the storage battery to discharge until 15 times, the measurement result of the battery reserve capacity of the storage battery is equal to a total of 14 times of 100RC; when an input signal is sent to the storage battery to control the storage battery to discharge until 10 times, the measurement result of the battery reserve capacity of the storage battery is equal to a total of 8 times of 100RC; the preset number of times may be set to 20 times.

As one of the implementation modes of the present invention, the input durations of at least two sent input signals are the same, or at least one input duration of the input durations of at least two sent input signals is different from other input durations.

In an embodiment of the present application, the continuous discharge time of the storage battery is equal to the input duration of the input signal during one discharge, i.e. at the beginning of the input signal, the storage battery is triggered to start discharging, and at the end of the input signal, the storage battery is triggered to end discharging. When the input signal is sent to the storage battery at least twice, the storage battery corresponds to at least two discharge processes, and the duration of each discharge of the storage battery may be the same or different, depending on the input duration of each input signal sent to the storage battery by the battery detection device.

Alternatively, the input duration has a duration unit of milliseconds, such as an input duration of 150ms.

An embodiment of the present application can determine the reserve capacity of the storage battery by inputting a signal to the storage battery for a relatively short time and guiding the storage battery to discharge, thereby saving the measurement duration of the reserve capacity of the storage battery and improving the user experience.

In the input duration of the input signal, the battery detection device controls the discharge of the storage battery, and the storage battery discharges to generate heat. According to the heat formula Q = I^2Rt, it can be known that when the storage battery discharges at a constant high current, the larger the input duration is, the higher the heat generated by the storage battery discharge. Therefore, by setting a sending interval between at least two transmissions of the input signal and limiting the input duration to the ms level, the storage battery is controlled to achieve intermittent high-current discharge so as to avoid the problem of a large amount of heat generated by the continuous discharge of the storage battery.

In an embodiment of the present invention, the input signal is a discharge current of the storage battery discharge and the output signal is an open circuit voltage fed back by the storage battery for the discharge current during the input duration. The value of the target discharge current is set in the battery detection device, and a voltage signal is output according to the target discharge current and a current-voltage relationship table pre-stored in the battery detection device, so as to control the discharge current of the storage battery to be equal to the target discharge current, namely, the current of the discharge loop of the battery detection device and the storage battery is equal to the target discharge current. Of course, the input signal to the storage battery and the output signal of the storage battery may also exist in other forms according to the detection requirements, such as the input signal being a load, or the input signal being a voltage, the output signal being a current, etc. which are not limited herein. In some embodiments, prior to sending an input signal to the storage battery to control the storage battery to discharge, the method further comprises: initializing the battery detection device.

Step S42, Determine a target battery parameter according to the output signal.

Determining a target battery parameter according to the output signal comprises detecting one set of battery parameters for each discharge of the storage battery based on the output signal; and screening an optimal battery parameter among at least two sets of voltage parameters as the target battery parameter. The battery parameter includes the maximum voltage, the minimum voltage, and a voltage drop slope for each discharge of the storage battery.

Further, screening an optimal voltage parameter among at least two sets of battery parameters as the target battery parameter comprises: selecting a maximum voltage with the maximum voltage of the at least two sets of battery parameters as the target maximum voltage; selecting a minimum voltage with the minimum voltage of the at least two sets of battery parameters as the target minimum voltage; and taking the target maximum voltage, the target minimum voltage, and a target voltage drop slope of the target maximum voltage corresponding to the target minimum voltage as the optimal battery parameter.

Step S43, acquire a battery capacity table, wherein the battery capacity table comprises a correlation between a battery parameter and a battery reserve capacity.

In an embodiment of the present invention, the battery capacity table comprises several battery reserve capacities and several sets of voltage parameters at each of the battery reserve capacities, each set of voltage parameters comprising several test voltages, and battery parameters resulting from discharging the storage battery at each test voltage. The several battery reserve capacities are spaced apart in between by a preset capacity and the several test voltages are spaced apart in between by a preset voltage.

The battery capacity table may be constructed in advance and stored in the battery detection device. As shown in Table 1, it shows a method for experimentally acquiring a battery capacity table. An experimental storage battery was selected by taking 10RC as the interval, and a test voltage was selected by taking 0.1V as the interval within a preset voltage range of 12.8V-8.0V; under one test voltage, according to steps S41 and S42, battery parameters under the test voltage were measured and recorded, and then constant current discharge was performed so that the voltage of the storage battery dropped to the next test voltage; the above operations were repeated, the battery parameters under the test voltage were recorded and thus the construction of the battery capacity table was completed.

**Table 1**

| Test Volt age (V) | 150RC | | | 140RC | | | 130RC | | | ...... | | |
|---|---|---|---|---|---|---|---|---|---|---|---|---|
| | Maxi mum volta ge | Mini mum volta ge | Volt age dro p slo pe | Maxi mum volta ge | Mini mum volta ge | Volt age dro p slo pe | Maxi mum volta ge | Mini mum volta ge | Volt age dro p slo pe | Maxi mum volta ge | Mini mum volta ge | Volt age dro p slo pe |
| 12. 8 | | | | | | | | | | | | |
| 12. 7 | | | | | | | | | | | | |
| 12. 6 | | | | | | | | | | | | |
| 12. 5 | | | | | | | | | | | | |
| 12. 4 | | | | | | | | | | | | |
| 12. 3 | | | | | | | | | | | | |
| 12. 2 | | | | | | | | | | | | |
| 12. 1 | | | | | | | | | | | | |
| 12. 0 | | | | | | | | | | | | |
| 11. 9 | | | | | | | | | | | | |
| ... | | | | | | | | | | | | |
| ... | | | | | | | | | | | | |
| 8.0 | | | | | | | | | | | | |

Specifically, constructing a battery capacity table in advance includes: providing several different kinds of experimental storage batteries of known battery reserve capacity; fully charging each experimental storage battery and stilling the same for a preset duration threshold (for example, 24h); after stilling for a preset duration threshold, controlling each experimental storage battery to discharge for a preset duration under each test voltage within a preset voltage measurement range, and recording the maximum voltage, the minimum voltage, and a voltage drop slope under the test voltage, wherein the test voltage = the right end point voltage of the preset voltage range - n* the preset voltage interval value, or the test voltage = the left end point voltage of the preset voltage range + n* the preset voltage interval value, n being the number of discharge measurements. Therefore, the battery capacity table was constructed based on the known maximum voltage, minimum voltage, and voltage drop slope for each test voltage under the battery reserve capacity.

It needs to be noted that the manner of measuring the battery parameters of the storage battery to be measured corresponds to the manner of measuring the battery parameters of the experimental storage battery in the battery capacity table.

For example, when constructing a battery capacity table in advance, the experimental storage battery performs m1 times of intermittent discharges under each test voltage, the sending intervals of the input signals sent m1 times are all equal to p1, the input durations of the input signals sent m1 times are all equal to q1, the duration of m1 times of intermittent discharges is equal to a preset duration t1, t1 = (m1-1) * p1 + m1 * q1, the maximum voltage, the minimum voltage, and a voltage drop slope of the m1 times of intermittent discharges under the test voltage are recorded, the maximum voltage of m1 times of the intermittent discharges is the maximum value of the maximum voltage of the m1 times of the intermittent discharges, the minimum voltage of m1 times of intermittent discharges is the minimum value of the minimum voltage of m1 times of the intermittent discharges, and the voltage drop slope of the maximum voltage of m1 times of the intermittent discharges is equal to (the maximum voltage of m1 times of the intermittent discharges - the minimum voltage of m1 times of the intermittent discharges) / the preset duration t1; then when measuring the battery reserve capacity of the storage battery to be measured, the input signal is sent to the storage battery m1 times to control the storage battery discharging such that the output signal fed back by the storage battery for the input signal within the input duration of the input signal is acquired, and the sending intervals of the input signal sent for m1 times are all equal to p1; the input durations of the input signals sent for m1 times are all equal to q1, the duration of m1 times of the intermittent discharges is equal to a preset duration t1, t1 = (m1-1) * p1 + m1 * q1, and a target battery parameter is determined according to the output signal, wherein the target battery parameter is the maximum voltage, the minimum voltage, and a voltage drop slope of m1 times of the intermittent discharges, the maximum voltage of m1 times of the intermittent discharges is the maximum value of the maximum voltage of m1 times of the intermittent discharges, and the minimum voltage of m1 times of the intermittent discharges is the minimum value of the minimum voltage of m1 times of the intermittent discharges; the voltage drop slope of the maximum voltage of m1 times of the intermittent discharges is equal to (the maximum voltage of m1 times of the intermittent discharges - the minimum voltage of m1 times of the intermittent discharges) / the preset duration t1.

Step S44, according to the battery capacity table and the target battery parameter, determine a battery reserve capacity corresponding to the target battery parameter.

Determining a battery reserve capacity corresponding to the target battery parameter according to the battery capacity table and the target battery parameter comprises inputting the target battery parameter to the battery capacity table; searching for a battery reserve capacity matching the target voltage drop slope in the battery capacity table, and taking the battery reserve capacity as the battery reserve capacity of the storage battery.

Further, the voltage drop slope of each of the battery parameters corresponds to one slope matching range. Searching for a battery reserve capacity matching the target voltage drop slope in the battery capacity table and taking the battery reserve capacity as a battery reserve capacity of the storage battery comprise determining whether the target voltage drop slope falls within a slope matching range of an effective voltage drop slope; and if so, taking the battery reserve capacity corresponding to the effective voltage drop slope as the battery reserve capacity of the storage battery.

The effective voltage drop slope is the best matching voltage drop slope of the target voltage drop slope.

Assuming that the target voltage drop slope is equal to 0.5V/t, the effective voltage drop slope is equal to 0.51V/t, the slope matching range is 0.51 ± 0.02V/t, and the battery reserve capacity corresponding to the effective voltage drop slope is equal to 150RC; then the target voltage drop slope 0.5V/t falls within the slope matching range 0.51 ± 0.02V/t of the effective voltage drop slope 0.51V/t, and the battery reserve capacity 150RC corresponding to the effective voltage drop slope 0.51V/t is taken as the battery reserve capacity of the storage battery, so as to realize the measurement of the battery reserve capacity of the storage battery.

It could be understood that determining the battery reserve capacity corresponding to the target battery parameter according to the battery capacity table and the target battery parameter is not limited to the preferred embodiments disclosed in the embodiments of the present invention. For example, a target differential pressure between the target maximum voltage and the target minimum voltage of the target battery parameter may be utilized to determine the battery reserve capacity corresponding to the target differential pressure. Searching for the voltage drop slope matching the target voltage drop slope in the battery capacity table is also not limited to the preferred embodiments disclosed in the embodiments of the present invention. For example, when the target voltage drop slope and one of the voltage drop slopes in the battery capacity table satisfy a preset matching condition, the battery reserve capacity corresponding to the voltage drop slope is taken as the battery reserve capacity of the storage battery, and when neither the target voltage drop slope nor the voltage drop slope in the battery capacity table satisfies the preset matching condition, the storage battery discharging step is returned to obtain a new target battery parameter.

An embodiment of the present invention provides a method for measuring a battery reserve capacity of a storage battery by sending an input signal to the storage battery to control the discharge of the storage battery, acquiring an output signal fed back by the storage battery for an input signal within an input duration of the input signal, determining a target battery parameter according to the output signal, acquiring a battery capacity table, the battery capacity table including a correlation between the battery parameter and the battery reserve capacity, and determining the battery reserve capacity corresponding to the target battery parameter according to the battery capacity table and the target battery parameter. Therefore, an embodiment of the present invention obtains the target battery parameter by controlling the storage battery to perform at least one discharge, and measures the battery reserve capacity of the storage battery according to the target battery parameter and the battery capacity table including the correlation between the battery parameter and the battery reserve capacity, thereby reducing the measurement time of the battery reserve capacity of the storage battery and improving the measurement efficiency.

Finally, it should be noted that: the above embodiments are merely illustrative of the technical solutions of the present invention, rather than limiting thereto; combinations of technical features in the above embodiments or in different embodiments are also possible within the idea of the present invention, and the steps can be implemented in any order, and there are many other variations of the different aspects of the present invention as described above, which are not provided in detail for the sake of brevity.

## Claims

1. A method for measuring a battery reserve capacity of a storage battery (200), wherein by being applied to a battery detection device (100) that is electrically connected to the storage battery (200) via a Kelvin connector, the method comprising:
sending an input signal to the storage battery (200) to control a discharging of the storage battery (200), and acquiring an output signal which is fed back, within an input duration of the input signal, by the storage battery (200) regarding the input signal;
determining a target battery parameter according to the output signal;
acquiring a battery capacity table, wherein the battery capacity table comprises a correlation between a battery parameter and a battery reserve capacity;
and according to the battery capacity table and the target battery parameter, determining a battery reserve capacity corresponding to the target battery parameter;
wherein the determining a target battery parameter from the output signal comprises:
detecting a set of battery parameters for each discharge of the storage battery (200) according to the output signal;
and screening an optimal battery parameter of at least two sets of voltage parameters as the target battery parameter;
wherein the battery parameters comprise a maximum voltage, a minimum voltage, and a voltage drop slope for each discharge of the storage battery (200);
wherein, the according to the battery capacity table and the target battery parameter, determining a battery reserve capacity corresponding to the target battery parameter comprises:
inputting the target battery parameter to the battery capacity table; and
searching for a battery reserve capacity matching the target voltage drop slope in the battery capacity table, and taking the battery reserve capacity as the battery reserve capacity of the storage battery (200);
**characterized in that** the voltage drop slope of each of the battery parameters corresponds to one slope matching range, the searching for a battery reserve capacity matching the target voltage drop slope in the battery capacity table, and taking the battery reserve capacity as the battery reserve capacity of the storage battery (200) comprising:
determining whether the target voltage drop slope falls within a slope matching range of an effective voltage drop slope;
and if so, taking the battery reserve capacity corresponding to the effective voltage drop slope as the battery reserve capacity of the storage battery (200).

2. The method of claim 1, wherein the sending an input signal to the storage battery (200) to control a discharging of the storage battery (200) comprises:
sending an input signal to the storage battery (200) at least twice to control the storage battery (200) to discharge.

3. The method of claim 2, wherein sending an input signal to the storage battery (200) at least twice to control the storage battery (200) to discharge comprises:
according to a preset frequency, sending an input signal to the storage battery (200) at least twice to control the storage battery (200) to discharge.

4. The method of claim 2, wherein a sending interval between at least two transmissions of the input signal is random.

5. The method of claim 2, wherein sending an input signal to the storage battery (200) at least twice to control the storage battery (200) to discharge comprises:
sending an input signal to the storage battery (200) at least twice to control the storage battery (200) to discharge until a preset number of times.

6. The method of claim 2, wherein the input durations of at least two sent input signals are the same, or at least one input duration of the input durations of at least two sent input signals is different from other input durations.

7. The method of claim 6, wherein the input duration has a duration unit of milliseconds, ms.

8. The method of any one of claims 1-7, wherein the input signal is a discharge current of storage battery discharge and the output signal is an open circuit voltage fed back by the storage battery (200) for the discharge current during the input duration.

9. The method of claim 1, wherein the screening an optimal battery parameter of at least two sets of voltage parameters as the target battery parameter comprises:
selecting a maximum voltage with a maximum voltage of the at least two sets of battery parameters as a target maximum voltage;
selecting a minimum voltage with a minimum voltage of the at least two sets of battery parameters as a target minimum voltage;
and taking the target maximum voltage, the target minimum voltage, and a target voltage drop slope of the target maximum voltage corresponding to the target minimum voltage as optimal battery parameters.

10. The method of claim 9, wherein the battery capacity table comprises several battery reserve capacities and several sets of voltage parameters at each of the battery reserve capacities, each set of voltage parameters comprising several test voltages, and battery parameters resulting from discharging the storage battery (200) under each test voltage, wherein the several battery reserve capacities are spaced apart in between by a preset capacity and the several test voltages are spaced apart in between by a preset voltage.

11. A battery detection device (100), wherein the battery detection device (100) is electrically connected to a storage battery (200) through a Kelvin connector, the battery detection device (100) comprising:
a discharge circuit (10) electrically connected to the storage battery (200) through the Kelvin connector,
wherein the discharge circuit is configured to send an input signal to the storage battery (200) to control a discharge of the storage battery (200);
a voltage sampling circuit (20) electrically connected to the storage battery (200) via the Kelvin connector,
wherein the voltage sampling circuit (20) is configured to sample an output signal fed back by the storage battery (200) for the input signal within an input duration of the input signal to obtain a sampling voltage;
and a controller (30, U3) electrically connected to the discharge circuit (10) and the voltage sampling circuit (20), respectively,
wherein the controller (30, U3) is configured to control the discharge circuit (10) so that the discharge circuit (10) sends the input signal to the storage battery (200);
wherein the controller (30, U3) is configured to determine a target battery parameter according to the sampling voltage by detecting a set of battery parameters for each discharge of the storage battery (200) according to the output signal, and screening an optimal battery parameter of at least two sets of voltage parameters as the target battery parameter;
wherein the battery parameters comprise a maximum voltage, a minimum voltage, and a voltage drop slope for each discharge of the storage battery (200);
wherein the voltage drop slope of each of the battery parameters corresponds to one slope matching range;
wherein the controller (30, U3) is configured to acquire a battery capacity table, wherein the battery capacity table comprises a correlation between a battery parameter and a battery reserve capacity; and
**characterized in that**, the controller (30, U3) is configured to determine a battery reserve capacity corresponding to the target battery parameter according to the battery capacity table and the target battery parameter by inputting the target battery parameter to the battery capacity table, and determining whether the target voltage drop slope falls within a slope matching range of an effective voltage drop slope; and if so, taking the battery reserve capacity corresponding to the effective voltage drop slope as the battery reserve capacity of the storage battery (200).

## Patentansprüche

1. Verfahren zur Messung einer Batteriereservekapazität einer Speicherbatterie (200), wobei das Verfahren, indem es auf eine Batterieerkennungsvorrichtung (100) angewandt wird, die mittels eines Kelvin-Verbinders elektrisch mit einer Speicherbatterie (200) verbunden ist, umfasst:
Senden eines Eingangssignals an die Speicherbatterie (200) zum Steuern eines Entladens der Speicherbatterie (200) und Erfassen eines Ausgangssignals, das innerhalb einer Eingangsdauer des Eingangssignals durch die Speicherbatterie (200) zurückgeführt wird, in Bezug auf das Eingangssignal;
Bestimmen eines Zielbatterieparameters gemäß dem Ausgangssignal;
Erfassen einer Batteriekapazitätstabelle, wobei die Batteriekapazitätstabelle eine Korrelation zwischen einem Batterieparameter und einer Batteriereservekapazität umfasst;
und, gemäß der Batteriekapazitätstabelle und dem Zielbatterieparameter, Bestimmen einer Batteriereservekapazität, die dem Zielbatterieparameter entspricht;
wobei das Bestimmen eines Zielbatterieparameters von dem Ausgangssignal umfasst:
Erkennen einer Menge von Batterieparametern für jede Entladung der Speicherbatterie (200) gemäß dem Ausgangssignal;
und Ermitteln eines optimalen Batterieparameters von mindestens zwei Mengen von Spannungsparametern als der Zielbatterieparameter;
wobei die Batterieparameter eine Höchstspannung, eine Mindestspannung und eine Spannungsabfallsteigung für jede Entladung der Speicherbatterie (200) umfassen;
wobei das Bestimmen einer Batteriereservekapazität, die dem Zielbatterieparameter entspricht, gemäß der Batteriekapazitätstabelle und dem Zielbatterieparameter umfasst:
Eingeben des Zielbatterieparameters in die Batteriekapazitätstabelle; und
Suchen nach einer Batteriereservekapazität, die mit der Zielspannungsabfallsteigung in der Batteriekapazitätstabelle übereinstimmt, und Nehmen der Batteriereservekapazität als die Batteriereservekapazität der Speicherbatterie (200);
**dadurch gekennzeichnet, dass** die Spannungsabfallsteigung jedes der Batterieparameter einem Steigungsübereinstimmungsbereich entspricht, wobei das Suchen einer Batteriereservekapazität, die mit der Zielspannungsabfallsteigung in der Batteriekapazitätstabelle übereinstimmt, und das Nehmen der Batteriereservekapazität als die Batteriereservekapazität der Speicherbatterie (200) umfassen:
Bestimmen, ob die Zielspannungsabfallsteigung innerhalb eines Steigungsübereinstimmungsbereichs einer effektiven Spannungsabfallsteigung fällt;
und, wenn dies der Fall ist, Nehmen der Batteriereservekapazität, die der effektiven Spannungsabfallsteigung entspricht, als die Batteriereservekapazität der Speicherbatterie (200).

2. Verfahren nach Anspruch 1, wobei das Senden eines Eingangssignals an die Speicherbatterie (200) zum Steuern eines Entladens der Speicherbatterie (200) umfasst:
Senden eines Eingangssignals an die Speicherbatterie (200) mindestens zwei Mal, um die Speicherbatterie (200) zum Entladen zu steuern.

3. Verfahren nach Anspruch 2, wobei das Senden eines Eingangssignals an die Speicherbatterie (200) mindestens zwei Mal, um die Speicherbatterie (200) zum Entladen zu steuern, umfasst:
gemäß einer voreingestellten Frequenz, Senden eines Eingangssignals an die Speicherbatterie (200) mindestens zwei Mal, um die Speicherbatterie (200) zum Entladen zu steuern.

4. Verfahren nach Anspruch 2, wobei ein Sendeintervall zwischen mindestens zwei Übermittlungen des Eingangssignals zufällig ist.

5. Verfahren nach Anspruch 2, wobei das Senden eines Eingangssignals an die Speicherbatterie (200) mindestens zwei Mal, um die Speicherbatterie (200) zum Entladen zu steuern, umfasst:
Senden eines Eingangssignals an die Speicherbatterie (200) mindestens zwei Mal, um die Speicherbatterie (200) zum Entladen zu steuern, bis zu einer voreingestellten Anzahl von Malen.

6. Verfahren nach Anspruch 2, wobei die Eingangsdauern von mindestens zwei gesendeten Eingangssignalen gleich sind oder mindestens eine Eingangsdauer der Eingangsdauern von mindestens zwei gesendeten Eingangssignalen sich von anderen Eingangsdauern unterscheidet.

7. Verfahren nach Anspruch 6, wobei die Eingangsdauer eine Dauereinheit von Millisekunden, ms, aufweist.

8. Verfahren nach einem der Ansprüche 1 bis 7, wobei das Eingangssignal ein Entladestrom der Speicherbatterieentladung ist und das Ausgangssignal eine Leerlaufspannung ist, die von der Speicherbatterie (200) für den Entladestrom während der Eingangsdauer zurückgeführt wird.

9. Verfahren nach Anspruch 1, wobei das Ermitteln eines optimalen Batterieparameters von mindestens zwei Mengen von Spannungsparametern als der Zielbatterieparameter umfasst:
Auswählen einer Höchstspannung mit einer Höchstspannung der mindestens zwei Mengen von Batterieparametern als eine Zielhöchstspannung;
Auswählen einer Mindestspannung mit einer Mindestspannung der mindestens zwei Mengen von Batterieparametern als eine Zielmindestspannung;
und Nehmen der Zielhöchstspannung, der Zielmindestspannung und einer Zielspannungsabfallsteigung der Zielhöchstspannung, die der Zielmindestspannung entspricht, als optimale Batterieparameter.

10. Verfahren nach Anspruch 9, wobei die Batteriekapazitätstabelle mehrere Batteriereservekapazitäten und mehrere Mengen von Spannungsparametern bei jeder der Batteriereservekapazitäten, wobei jede Menge von Spannungsparametern mehrere Testspannungen umfasst, und Batterieparameter umfasst, die aus dem Entladen der Speicherbatterie (200) unter jeder Testspannung resultieren, wobei die mehreren Batteriereservekapazitäten zwischen einer voreingestellten Kapazität voneinander beabstandet sind und die mehreren Testspannungen zwischen einer voreingestellten Spannung voneinander beabstandet sind.

11. Batterieerkennungsvorrichtung (100), wobei die Batterieerkennungsvorrichtung (100) durch einen Kelvin-Verbinder elektrisch mit einer Speicherbatterie (200) verbunden ist, wobei die Batterieerkennungsvorrichtung (100) umfasst:
eine Entladungsschaltung (10), die durch den Kelvin-Verbinder elektrisch mit der Speicherbatterie (200) verbunden ist,
wobei die Entladungsschaltung dazu ausgestaltet ist, ein Eingangssignal an die Speicherbatterie (200) zu senden, um eine Entladung der Speicherbatterie (200) zu steuern,
eine Spannungsabtastungsschaltung (20), die über den Kelvin-Verbinder elektrisch mit der Speicherbatterie (200) verbunden ist,
wobei die Spannungsabtastungsschaltung (20) dazu ausgestaltet ist, ein Ausgangssignal, das von der Speicherbatterie (200) für das Eingangssignal innerhalb einer Eingangsdauer des Eingangssignals zurückgeführt wird, abzutasten, um eine Abtastspannung zu erhalten;
und eine Steuereinrichtung (30, U3), die elektrisch mit der Entladungsschaltung (10) beziehungsweise der Spannungsabtastungsschaltung (20) verbunden ist;
wobei die Steuereinrichtung (30, U3) dazu ausgestaltet ist, die Entladungsschaltung (10) derart zu steuern, dass die Entladungsschaltung (10) das Eingangssignal an die Speicherbatterie (200) sendet;
wobei die Steuereinrichtung (30, U3) dazu ausgestaltet ist, einen Zielbatterieparameter gemäß der Abtastspannung durch Erkennen einer Menge von Batterieparametern für jede Entladung der Speicherbatterie (200) gemäß dem Ausgangssignal zu bestimmen, und einen optimalen Batterieparameter von mindestens zwei Mengen von Spannungsparametern als den Zielbatterieparameter zu ermitteln;
wobei die Batterieparameter eine Höchstspannung, eine Mindestspannung und eine Spannungsabfallsteigung für jede Entladung der Speicherbatterie (200) umfassen;
wobei die Spannungsabfallsteigung von jedem der Batterieparameter einem Steigungsabgleichbereich entspricht;
wobei die Steuereinrichtung (30, U3) dazu ausgestaltet ist, eine Batteriekapazitätstabelle zu erfassen, wobei die Batteriekapazitätstabelle eine Korrelation zwischen einem Batterieparameter und einer Batteriereservekapazität umfasst; und
**dadurch gekennzeichnet, dass** die Steuereinrichtung (30, U3) dazu ausgestaltet ist, eine Batteriereservekapazität, die dem Zielbatterieparameter entspricht, gemäß der Batteriekapazitätstabelle und dem Zielbatterieparameter durch Eingeben des Zielbatterieparameters in die Batteriekapazitätstabelle und Bestimmen, ob die Zielspannungsabfallsteigung innerhalb eines Steigungsübereinstimmungsbereichs einer effektiven Spannungsabfallsteigung fällt, zu bestimmen; und, wenn dies der Fall ist, Nehmen der Batteriereservekapazität, die der effektiven Spannungsabfallsteigung entspricht, als die Batteriereservekapazität der Speicherbatterie (200).

## Revendications

1. Procédé pour mesurer une capacité de réserve de batterie d'une batterie rechargeable (200), dans lequel, en étant appliqué à un dispositif de détection de batterie (100) qui est connecté électriquement à la batterie rechargeable (200) via un connecteur Kelvin, le procédé comprend les étapes suivantes :
envoyer un signal d'entrée à la batterie rechargeable (200) pour commander une décharge de la batterie rechargeable (200), et acquérir un signal de sortie qui est renvoyé pendant une durée d'entrée du signal d'entrée par la batterie rechargeable (200) concernant le signal d'entrée ;
déterminer un paramètre de batterie cible selon le signal de sortie ;
acquérir une table de capacité de batterie, dans lequel la table de capacité de batterie comprend une corrélation entre un paramètre de batterie et une capacité de réserve de batterie ;
et selon la table de capacité de batterie et le paramètre de batterie cible, déterminer une capacité de réserve de batterie correspondant au paramètre de batterie cible ;
dans lequel le fait de déterminer un paramètre de batterie cible à partir du signal de sortie comprend ce qui suit :
détecter un ensemble de paramètres de batterie pour chaque décharge de la batterie rechargeable (200) selon le signal de sortie ;
et trier un paramètre de batterie optimal d'au moins deux ensembles de paramètres de tension comme paramètre de batterie cible ;
dans lequel les paramètres de batterie comprennent une tension maximale, une tension minimale et une pente de chute de tension pour chaque décharge de la batterie rechargeable (200) ;
dans lequel le fait de déterminer une capacité de réserve de batterie correspondant au paramètre de batterie cible selon la table de capacité de batterie et le paramètre de batterie cible comprend ce qui suit :
entrer le paramètre de batterie cible dans la table de capacité de batterie ; et
rechercher une capacité de réserve de batterie concordant avec la pente de chute de tension cible dans la table de capacité de batterie, et prendre la capacité de réserve de batterie comme capacité de réserve de batterie de la batterie rechargeable (200) ;
**caractérisé en ce que** la pente de chute de tension de chacun des paramètres de batterie correspond à une plage de concordance de pente, le fait de rechercher une capacité de réserve de batterie concordant avec la pente de chute de tension cible dans la table de capacité de batterie, et le fait de prendre la capacité de réserve de batterie comme capacité de réserve de batterie de la batterie rechargeable (200) comprennent ce qui suit :
déterminer si la pente de chute de tension cible se situe dans une plage de concordance de pente d'une pente de chute de tension effective ;
et si tel est le cas, prendre la capacité de réserve de batterie correspondant à la pente de chute de tension effective comme capacité de réserve de batterie de la batterie rechargeable (200).

2. Procédé selon la revendication 1, dans lequel le fait d'envoyer un signal d'entrée à la batterie rechargeable (200) pour commander une décharge de la batterie rechargeable (200) comprend ce qui suit :
envoyer un signal d'entrée à la batterie rechargeable (200) au moins deux fois pour commander la décharge de la batterie rechargeable (200).

3. Procédé selon la revendication 2, dans lequel le fait d'envoyer un signal d'entrée à la batterie rechargeable (200) au moins deux fois pour commander la décharge de la batterie rechargeable (200) comprend ce qui suit :
selon une fréquence prédéfinie, envoyer un signal d'entrée à la batterie rechargeable (200) au moins deux fois pour commander la décharge de la batterie rechargeable (200).

4. Procédé selon la revendication 2, dans lequel un intervalle d'envoi entre au moins deux transmissions du signal d'entrée est aléatoire.

5. Procédé selon la revendication 2, dans lequel le fait d'envoyer un signal d'entrée à la batterie rechargeable (200) au moins deux fois pour commander la décharge de la batterie rechargeable (200) comprend ce qui suit :
envoyer un signal d'entrée à la batterie rechargeable (200) au moins deux fois pour commander la décharge de la batterie rechargeable (200) jusqu'à un nombre prédéfini de fois.

6. Procédé selon la revendication 2, dans lequel les durées d'entrée d'au moins deux signaux d'entrée envoyés sont identiques, ou au moins une durée d'entrée des durées d'entrée d'au moins deux signaux d'entrée envoyés est différente des autres durées d'entrée.

7. Procédé selon la revendication 6, dans lequel la durée d'entrée une unité de durée de millisecondes, ms.

8. Procédé selon l'une des revendications 1 à 7, dans lequel le signal d'entrée est un courant de décharge pour la décharge de batterie rechargeable, et le signal de sortie est une tension de circuit ouvert renvoyée par la batterie rechargeable (200) pour le courant de décharge pendant la durée d'entrée.

9. Procédé selon la revendication 1, dans lequel le fait de trier un paramètre de batterie optimal d'au moins deux ensembles de paramètres de tension comme paramètre de batterie cible comprend ce qui suit :
sélectionner une tension maximale avec une tension maximale des au moins deux ensembles de paramètres de batterie comme tension maximale cible ;
sélectionner une tension minimale avec une tension minimale des au moins deux ensembles de paramètres de batterie comme tension minimale cible ;
et prendre la tension maximale cible, la tension minimale cible et une pente de chute de tension cible de la tension maximale cible correspondant à la tension minimale cible comme paramètres de batterie optimaux.

10. Procédé selon la revendication 9, dans lequel la table de capacité de batterie comprend de multiples capacités de réserve de batterie et de multiples ensembles de paramètres de tension à chacune des capacités de réserve de batterie, chaque ensemble de paramètres de tension comprenant de multiples tensions de test et des paramètres de batterie résultant de la décharge la batterie rechargeable (200) sous chaque tension de test, dans lequel les multiples capacités de réserve de batterie sont espacées entre elles d'une capacité prédéfinie, et les multiples tensions de test sont espacées entre elles d'une tension prédéfinie.

11. Dispositif de détection de batterie (100), dans lequel le dispositif de détection de batterie (100) est connecté électriquement à une batterie rechargeable (200) via un connecteur Kelvin, le dispositif de détection de batterie (100) comprenant :
un circuit de décharge (10) connecté électriquement à la batterie rechargeable (200) via le connecteur Kelvin,
dans lequel le circuit de décharge est configuré pour envoyer un signal d'entrée à la batterie rechargeable (200) pour commander une décharge de la batterie rechargeable (200) ;
un circuit d'échantillonnage de tension (20) connecté électriquement à la batterie rechargeable (200) via le connecteur Kelvin,
dans lequel le circuit d'échantillonnage de tension (20) est configuré pour échantillonner un signal de sortie renvoyé par la batterie rechargeable (200) pour le signal d'entrée pendant une durée d'entrée du signal d'entrée afin d'obtenir une tension d'échantillonnage ;
et un dispositif de commande (30, U3) connecté électriquement au circuit de décharge (10) et au circuit d'échantillonnage de tension (20), respectivement,
dans lequel le dispositif de commande (30, U3) est configuré pour commander le circuit de décharge (10) de sorte que le circuit de décharge (10) envoie le signal d'entrée à la batterie rechargeable (200) ;
dans lequel le dispositif de commande (30, U3) est configuré pour déterminer un paramètre de batterie cible selon la tension d'échantillonnage en détectant un ensemble de paramètres de batterie pour chaque décharge de la batterie rechargeable (200) selon le signal de sortie, et en triant un paramètre de batterie optimal d'au moins deux ensembles de paramètres de tension comme paramètre de batterie cible ;
dans lequel les paramètres de batterie comprennent une tension maximale, une tension minimale et une pente de chute de tension pour chaque décharge de la batterie rechargeable (200) ;
dans lequel la pente de chute de tension de chacun des paramètres de batterie correspond à une plage de concordance de pente ;
dans lequel le dispositif de commande (30, U3) est configuré pour acquérir une table de capacité de batterie, dans lequel la table de capacité de batterie comprend une corrélation entre un paramètre de batterie et une capacité de réserve de batterie ; et
**caractérisé en ce que**,
le dispositif de commande (30, U3) est configuré pour déterminer une capacité de réserve de batterie correspondant au paramètre de batterie cible selon la table de capacité de batterie et le paramètre de batterie cible en entrant le paramètre de batterie cible dans la table de capacité de batterie, et en déterminer si la pente de chute de tension cible se situe dans une plage de concordance de pente d'une pente de chute de tension effective ; et si tel est le cas, en prenant la capacité de réserve de batterie correspondant à la pente de chute de tension effective comme capacité de réserve de batterie de la batterie rechargeable (200).
